(19) Europäisches Patentamt
European Patent Office
Office européen des brevets

(11) EP 2 999 002 A1

(12) **EUROPEAN PATENT APPLICATION**

(43) Date of publication:
23.03.2016 Bulletin 2016/12

(51) Int Cl.:
*H01L 29/94* (2006.01)     *H01L 23/64* (2006.01)
*H01L 29/66* (2006.01)     *H01G 4/08* (2006.01)
*H01L 21/314* (2006.01)

(21) Application number: 14290286.5

(22) Date of filing: 18.09.2014

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME

(71) Applicants:
• Services Petroliers Schlumberger
75007 Paris (FR)
Designated Contracting States:
FR
• Schlumberger Holdings Limited
Road Town, Tortola 1110 (VG)
Designated Contracting States:
FR GB NL
• Schlumberger Technology B.V.
2514 JG The Hague (NL)
Designated Contracting States:
AL AT BE BG CH CY CZ DE DK EE ES FI FR GR HR HU IE IS IT LI LT LU LV MC MK MT NO PL PT RO RS SE SI SK SM TR

(72) Inventor: Robutel, Rémi
78990 Elancourt (FR)

(74) Representative: Leonori, Céline
Etudes et Productions Schlumberger
Intellectual Property Department
1, rue Henri Becquerel
B.P. 202
92142 Clamart Cedex (FR)

(54) **Capacitor cell and method for manufacturing same**

(57) Disclosed is a high density, high reliability capacitor that is capable of operating at high temperature, for example for use in downhole tools. The capacitive cells have an insulating dielectric of crystalline diamond deposited on a substrate of silicon. Methods of manufacturing capacitor cells are also disclosed, as are stacked configurations of single die capacitors.

Figure 2b

**Description**

FIELD

Embodiments of the present invention relate to a capacitor cell and a method for manufacturing a capacitor cell. Merely by way of example, the capacitor cell may comprise a polycrystalline diamond capacitor and a method for manufacturing such a capacitor. In some embodiments, the capacitor cells may be use in high temperature environments, for example in downhole applications in the oil and gas industries.

BACKGROUND

Existing silicon-based capacitors have been commercialized with high density and high reliability features at high temperature. The electrical performance and reliability of such silicon-based capacitors are very attractive compared to other technologies like tantalum or ceramic capacitors.

Silicon-based capacitor technology is fairly mature and uses advanced clean room processes, such as Deep Reactive Ion Etching (DRIE). Silicon-based capacitor technology is based mainly on the dielectric properties of the silicon di-oxide ($SiO_2$) or Hafnium oxide ($HfO_2$) which are currently used as dielectrics in microelectronics.

However, a limitation of such technology comes from the voltage rating, which only provides for low voltages, typically below about 15 Volts (V). Additionally, the more the voltage increases, the more the density decreases in term of capacitance per surface unit, typically in the range from 25 to 250 nF/mm$^2$ (nanofarads per square millimetre).

In recent years, three-dimensional arrangements of capacitor cells have been developed in which the density of the cell can be improved by increasing the surface area of the dielectric between the electrodes of the cell.

One of the objects of the present invention is to provide capacitor cells and methods for manufacturing such capacitor cells that provide a high density, high reliability capacitor, in particular one that can operate at high temperature. In some aspects, operation may be above about 150° C, 175° C or 200° C. Such capacitors having application in downhole tools used in the oil and gas exploration and production industries.

SUMMARY

Aspects of the present invention provide capacitor cells and methods of manufacturing capacitor cells in which a diamond dielectric layer is used.

The disclosure relates to a capacitor cell comprising a semi-conductor assembly comprising a substrate of semi-conductor material having a plurality of cavities etched into a top surface thereof; a dielectric insulator layer of crystalline diamond formed on said semi-conductor assembly;a top layer electrode formed on said diamond layer; a bottom layer electrode formed on a bottom surface of the substrate of said semi-conductor assembly ; and an insulating layer formed on said top electrode layer and having a plurality of openings to provide access to said top electrode layer.

A first aspect of an embodiment of the present invention provides a capacitor cell comprising: a substrate of intrinsic semi-conductor material having a plurality of cavities etched into a top surface thereof; an inner electrode formed on said top surface; a dielectric insulator layer of crystalline diamond formed on said inner electrode; a top layer electrode formed on said diamond layer; a bottom layer electrode formed on a bottom surface of said substrate; and an insulating layer formed on said top electrode layer and having a plurality of openings to provide access to said top electrode layer.

In some embodiments, the inner electrode is a layer of ion implanted n-type dopant or is metal or a multilayer metallization.

A second aspect of an embodiment of the present invention provides a capacitor cell comprising: a substrate of highly doped n-type semi-conductor material having a plurality of cavities etched into a top surface thereof; a dielectric insulator layer of crystalline diamond formed on said substrate; a top layer electrode formed on said diamond layer; a bottom layer electrode formed on a bottom surface of said substrate; and an insulating layer formed on said top electrode layer and having a plurality of openings to provide access to said top electrode layer.

The capacitor cells according to the above first and second aspects differ in the type of semi-conductor substrate used. In the first aspect, an intrinsic material (e.g. bulk silicon) is used. In the second aspect, a highly-doped (N++) material (e.g. highly-doped silicon) is used. In other embodiments, different semi-conductor materials may also be used, such as, for example GaN, SiC, GaAs and/or the like.

As a result of the difference in substrates, the capacitor cells of the first and second aspects also differ in the provision of an inner electrode. Where the substrate is intrinsic, an inner electrode may be separately formed. Where the substrate is already highly-doped, the electrode may be directly composed of the substrate itself and not separately formed.

The optional and preferred features of the capacitor cells set out below apply to both the first and second aspects set out above.

In embodiments of the present invention, diamond, a carbon (poly)-crystalline material, provides a wide range of attractive intrinsic characteristics for dielectric use (e.g. Young modulus, chemically inert, thermal conductivity, dielectric strength) with good reproducibility when deposited by CVD techniques or the like. Techniques for deposition may comprise, CVD, Plasma Enhanced Chemical Vapor Deposition (PECVD), Microwave PECVD (MPECVD), High Pressure High Temperature (HPHT) crystal growth and/or the like.

In embodiments of the present invention, a high capacitive energy per unit volume can be achieved in the capacitor cell by use of a diamond dielectric and the three dimensional structure of the capacitor cell.

In some embodiments, the diamond dielectric layer is deposited by Chemical Vapor Deposition (CVD) techniques. In an embodiment of the present invention, CVD is used to deposit and work with synthetic diamond with respect to a large variety of substrates, environments and geometries. For instance, in some embodiments, substrate materials such as alloys, silicon wafers and conventional metals (Cu, Ag, Au, Pt and/or the like) may be used with the diamond dielectric layer.

By using diamond as a dielectric layer, in accordance with an embodiment of the present invention, a capacitor cell can be provided which has high density, high reliability and is capable of operation at high temperatures (up to and above 200 °C).

The geometries of the cavities can also be designed to optimize the density and reliability of the capacitor cells. Various possible geometries are set out in the detailed description below.

In certain embodiments, the top layer electrode comprises a thin layer of highly doped crystalline diamond.

In some embodiments, the top layer electrode is metallized to allow the connection of other contacts.

The insulating layer formed on said top electrode layer protects the top electrode (particularly where metallized) from mechanical, electrical and chemical damage. In embodiments of the present invention, the layer may comprise an organic or inorganic layer and/or may comprise a multilayer structure.

The capacitor cells of the above first and second aspects may include any combination of some, all or none of the above described preferred and optional features.

A third aspect of an embodiment of the present invention provides a capacitor comprising a stack of capacitor cells, each cell being an identical capacitor cell according to the above first or second aspect, including some or all features of those aspects, and wherein the cells are connected by bonding the top and bottom layer electrodes of neighbouring cells in the stack to each other.

In some embodiments of the present invention, by adopting a modular approach of identical capacitor cells, robust and easy stacking of individual capacitor cells within a device can be achieved. In some embodiments, the electrodes of the cells may be bonded to each other and to a substrate (which may comprise a metallized ceramic substrate with a conductive layer) by conductive attachment material, and the whole may be encapsulated in an insulating material such as silicone or other polymeric material.

Another aspect of an embodiment of the present invention provides a method of manufacturing a capacitor cell, the method including the steps of providing a plurality of cavities in a top surface of a substrate of semi-conductor material. In some aspects, the cavities are produced using etching, such as deep reactive ion etching or the like. Etching methods may be used that provide deep cavities in the substrate.

The substrate may be made of intrinsic semi-conductor material.

The method of manufacture in accordance with an embodiment of the present invention, includes, forming an inner electrode on said top surface depositing a thin layer of crystalline diamond on said inner electrode as a dielectric insulator layer, creating an electrically conductive top layer electrode on said diamond layer, finishing said top electrode layer by thin film metallization, creating an electrically conductive bottom electrode layer on a bottom surface of said substrate, finishing said bottom electrode layer by thin film metallization, forming an insulating layer on said top electrode layer, and forming openings in said insulating layer to provide access to said top electrode layer.

In some embodiments, the inner electrode is a layer of ion implanted n-type dopant or is metal or a multilayer metallization, which may be formed by sputtering, CVD, PECVD, MPECVD and/or the like.

The substrate may be made of highly doped n-type semi-conductor material.

The method may include the steps of: etching a plurality of cavities into a top surface of a substrate of highly doped n-type semi-conductor material with a high conductivity; depositing a thin layer of crystalline diamond on said substrate as a dielectric insulator layer; creating an electrically conductive top layer electrode on said diamond layer; finishing said top electrode layer by thin film metallization; creating an electrically conductive bottom electrode layer on the bottom side of said substrate; finishing said bottom electrode layer by thin film metallization; forming an insulating layer on said top electrode layer; and forming openings in said insulating layer to provide access to said top electrode layer.

The methods according to the above fourth and fifth aspects differ in the type of semi-conductor substrate used. In the fourth aspect, an intrinsic material (e.g. bulk silicon or the like) is used. In the fifth aspect, a highly-doped (N++) material (e.g. highly-doped silicon or the like) is used. Other semi-conductor materials may also be used, such as GaN, SiC and GaAs.

As a result of the difference in substrates, the method of the fourth aspect includes an additional step of forming an inner electrode. In embodiments where the substrate is intrinsic, an inner electrode needs to be separately formed. In embodiments where the substrate is already highly-doped,. the electrode can be directly composed of the substrate itself and is not separately formed.

The optional and preferred features of the methods set out below apply to both the fourth and fifth aspects set out above.

In some embodiments, the diamond layer is deposited by CVD, PECVD, MPECVD, HPHT crystal growth or the like. In some embodiments of the present invention, use of CVD to deposit and work with synthetic diamond provides for use of a large variety of substrates, environments and generation of a broad range of geometries. For instance, substrate materials such as alloys, silicon wafers and conventional metals (Cu, Ag, Au, Pt...) are compatible with diamond CVD techniques.

By combining microelectronics processes, such as DRIE or the like and the use of diamond, for example deposited by CVD, as a dielectric layer, the method can produce a capacitor cell which has high density, high reliability and is capable of operation at high temperatures (above 200 °C).

Scalability of the method of these aspects can be provided by ensuring a compatibility with standard clean room processes.

In certain embodiments, the top layer electrode is a thin layer of highly doped crystalline diamond.

In some embodiments the top layer electrode is metallized to allow the connection of other contacts.

The insulating layer formed on said top electrode layer protects the top electrode (particularly where metallized) from mechanical, electrical and chemical damage. In some embodiments, the insulating layer may comprise an organic or inorganic layer and may have a multilayer structure.

The methods of the above fourth and fifth aspects may include any combination of some or all features of the fourth and fifth aspects..

BRIEF DESCRIPTION OF THE DRAWINGS

Embodiments of the invention will now be described by way of example with reference to the accompanying drawings in which:

Figures 1a-1k illustrate a method of manufacturing a capacitive cell according to an embodiment of the present invention;

Figures 2a and 2b illustrate finished capacitive cells according to embodiments of the present invention;

Figures 3a-3d illustrate possible geometries of the cavities in the capacitive cells;

Figure 4 shows the configuration of a capacitive cell making up a single die for use in a stacked die capacitor according to an embodiment of the invention;

Figure 5 shows a stacked die according to an embodiment of the invention using the die shown in Figure 4;

Figure 6 shows an alternative configuration of a capacitive cell making up a single die for use in a stacked die capacitor according to an embodiment of the invention;

Figure 7 shows a stacked die according to an embodiment of the invention using the die shown in Figure 6;

Figs. 8a and 8b illustrate decoupling capacitors, in accordance with embodiments of the present invention, and pull-up/pull-down resistors within the same die/chip;

Figs. 9a and 9b illustrate capacitors, in accordance with embodiments of the present invention, incorporated in resistor-capacitor (RC) filters; and

Fig. 10 illustrates capacitors, in accordance with embodiments of the present invention, integrated in a circuit as by-pass capacitors/analog capacitors.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

## DETAILED DESCRIPTION

The ensuing description provides preferred exemplary embodiment(s) only, and is not intended to limit the scope, applicability or configuration of the invention. Rather, the ensuing description of the preferred exemplary embodiment(s) will provide those skilled in the art with an enabling description for implementing a preferred exemplary embodiment of the invention. It being understood that various changes may be made in the function and arrangement of elements without departing from the scope of the invention as set forth in the appended claims.

Specific details are given in the following description to provide a thorough understanding of the embodiments. However, it will be understood by one of ordinary skill in the art that the embodiments maybe practiced without these specific details. For example, circuits may be shown in block diagrams in order not to obscure the embodiments -in unnecessary detail. In other instances, well-known circuits, processes, algorithms, structures, and techniques may be shown without unnecessary detail in order to avoid obscuring the embodiments.

Also, it is noted that the embodiments may be described as a process which is depicted as a flowchart, a flow diagram, a data flow diagram, a structure diagram, or a block diagram. Although a flowchart may describe the operations as a sequential process, many of the operations can be performed in parallel or concurrently. In addition, the order of the operations may be re-arranged. A process is terminated when its operations are completed, but could have additional steps not included in the figure. A process may correspond to a method, a function, a procedure, a subroutine, a subprogram, etc. When a process corresponds to a function, its termination corresponds to a return of the function to the calling function or the main function.

Moreover, as disclosed herein, the term "storage medium" may represent one or more devices for storing data, including read only memory (ROM), random access memory (RAM), magnetic RAM, core memory, magnetic disk storage mediums, optical storage mediums, flash memory devices and/or other machine readable mediums for storing information. The term "computer-readable medium" includes, but is not limited to portable or fixed storage devices, optical storage devices, wireless channels and various other mediums capable of storing, containing or carrying instruction(s) and/or data.

Furthermore, embodiments may be implemented by hardware, software, firmware, middleware, microcode, hardware description languages, or any combination thereof. When implemented in software, firmware, middleware or microcode, the program code or code segments to perform the necessary tasks may be stored in a machine readable medium such as storage medium. A processor(s) may perform the necessary tasks. A code segment may represent a procedure, a function, a subprogram, a program, a routine, a subroutine, a module, a software package, a class, or any combination of instructions, data structures, or program statements. A code segment may be coupled to another code segment or a hardware circuit by passing and/or receiving information, data, arguments, parameters, or memory contents. Information, arguments, parameters, data, etc. may be passed, forwarded, or transmitted via any suitable means including memory sharing, message passing, token passing, network transmission, etc.

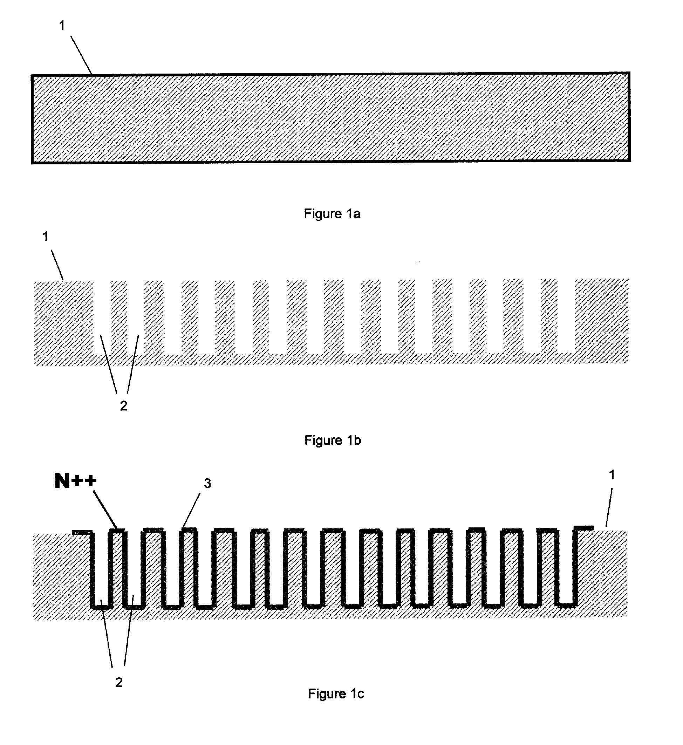

A method of manufacturing a capacitive cell according to an embodiment of the present invention is set out step-wise below (cleaning and other non-critical steps which will be readily apparent to the person skilled in the art are not listed to avoid unnecessary information), with reference to Figures 1a-1k.

**Initial substrate** (Figure 1a). The process starts with a polycrystalline or monocrystalline substrate material 1 which is called a "wafer". The wafer may be composed of intrinsic silicon (or bulk silicon) with low conductivity (I) or highly doped silicon with high conductivity (N++). The wafer may be composed of another intrinsic semi-conductor material or another highly doped semi-conductor material. For instance, other semi-conductor materials may be GaN, SiC, GaAs or the like.

**DRIE** (Figure 1b). The substrate 1 is deeply etched by DRIE (Deep Reactive Ion Etching) or the like. Possible mask geometries are set out below. This step creates a number of cavities 2 into the substrate to increase the surface of the substrate 1.

**Implantation (optional)** (Figure 1c). If the polycrystalline or monocrystalline substrate 1 is an intrinsic material, a process step of doping by ion implantation of an n-type dopant is required in order to increase electrical conductivity to create an inner electrode 3. Alternatively to such implantation, the inner electrode 3 may be a metal or a multilayer metallization deposited by thin film deposition techniques such as sputtering.

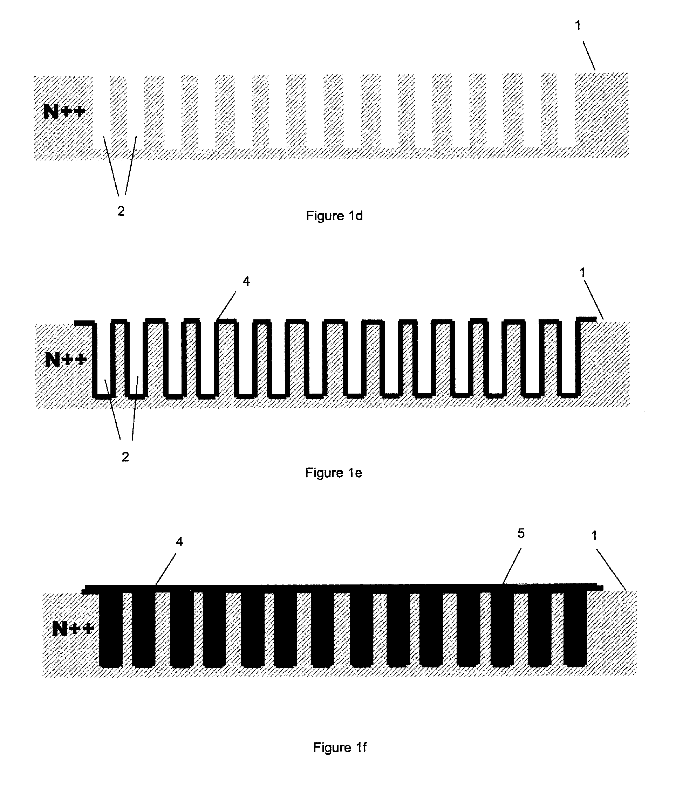

Two cases are illustrated in Figures 1c and 1d: full N++ (Figure 1c) or intrinsic substrate (Figure 1d). When the substrate 1 is a full N++ substrate (highly conductive substrate), the inner electrode is directly composed of the N++, etched substrate itself and so the implantation step is not required.

Figures 1e-1k, which illustrate the subsequent steps, will be shown for the full N++ substrate only, but the skilled person will readily appreciate that the same steps are applicable for the intrinsic substrate with the implanted inner electrode 3. /

**Dielectric Diamond Deposition** (Figure 1e): a thin film of polycrystalline or monocrystalline diamond 4 is deposited by CVD or the like. The dielectric diamond layer 4 is an insulating layer.

**Top Electrodes Deposition** (Figure 1f): a thin film of highly doped polycrystalline or monocrystalline diamond is deposited by CVD or the like, or a thin film metallization is performed with metal or alloys (Al, Au, Ti, Cr, Ag, Pd and/or the like) in order to create the top electrode layer 5. The top electrode layer is an electrically conductive layer. Note that this layer of conductive material may not fill entirely or cover entirely the three dimensional geometry of the substrate cavities. Top electrodes deposition may be deposited on different and insulated potentials (or nets) depending on mask design.

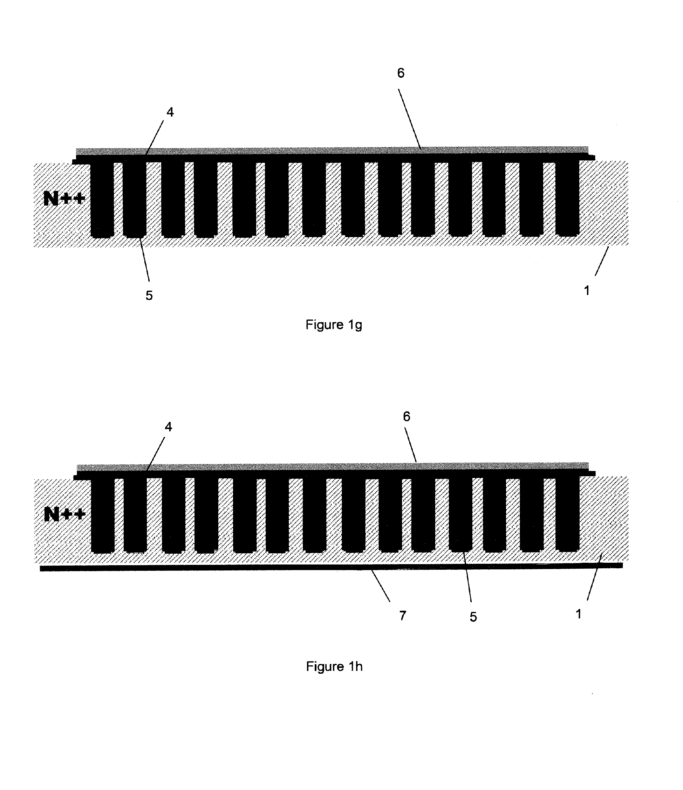

**Top Electrodes Finish** (Figure 1g): a thin film metallization 6 is performed with metals or alloys (Al, Au, Ti, Cr, Ag, Pd and/or the like) in order to adapt the metallurgy with microelectronic packaging technologies, fill or cover void geometric irregularities, and increase the thickness of the top electrode 5. Top electrode finish may be deposited on different and insulated potentials (or nets) depending on mask design.

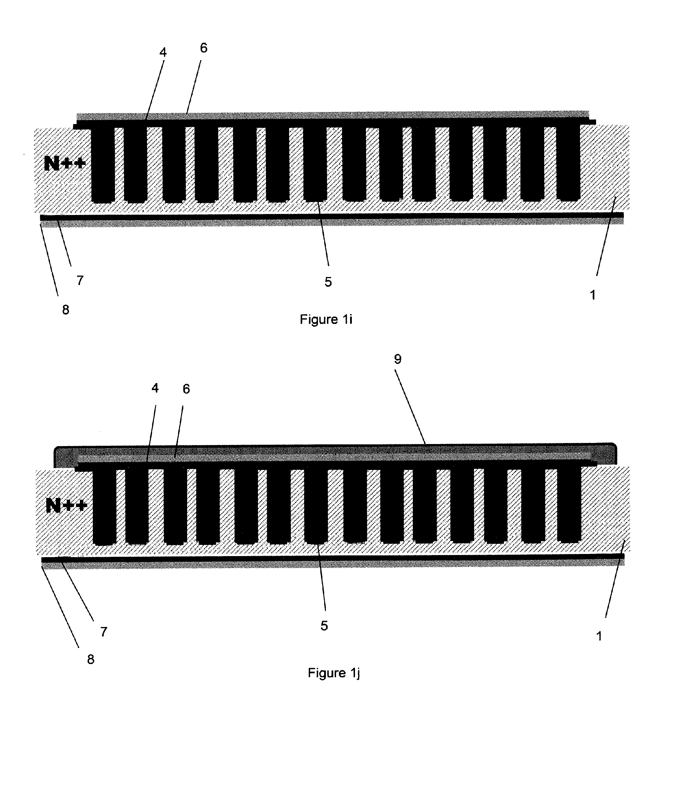

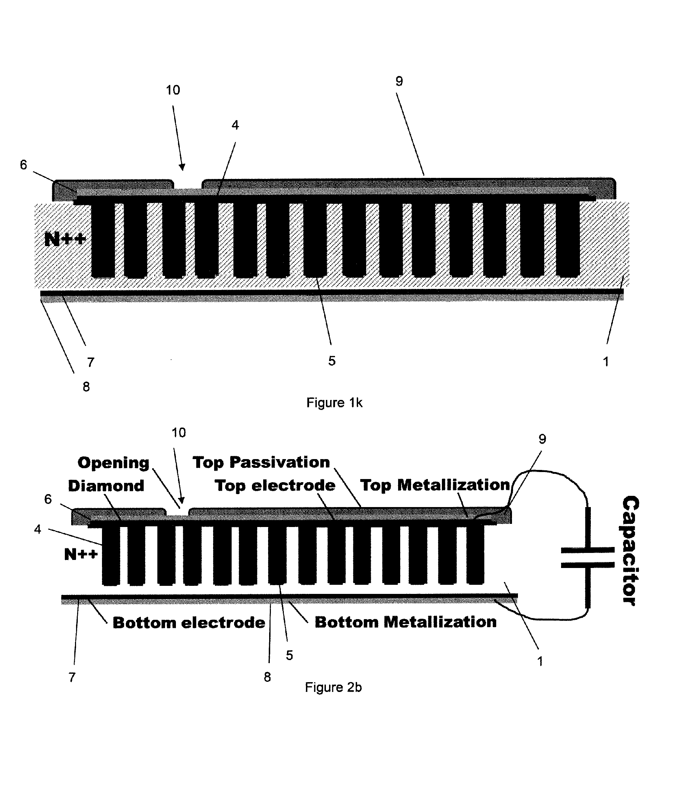

**Bottom Electrodes Deposition** (Figure 1 h): a thin film of highly doped polycrystalline or monocrystalline diamond is deposited by CVD or the like, or a thin film metallization is performed with typical metals or alloys (Al, Au, Ti, Cr, Ag, Pd...) in order to create the contacts of the bottom electrode layer 7. The bottom electrode layer 7 is an electrically conductive layer. Note that this layer of conductive material may not fill entirely or cover entirely three dimensional geometry of the substrate.

**Bottom Electrodes Finish** (Figure 1 i): a thin film metallization 8 is performed with metals or alloys (Al, Au, Ti, Cr, Ag, Pd and/or the like) in order to adapt the metallurgy with microelectronic packaging technologies, fill or cover void geometric irregularities, and increase the thickness of the bottom electrode 7.

**Top passivation** (Figure 1j): the top passivation 9 is an insulating layer that protects the top metallization from being damaged (mechanically, electrically, chemically...). It can be an organic or an inorganic layer, and it may be composed of a multilayered structure, such as a primary passivation and a secondary passivation.

**Top Electrodes Opening** (Figure 1 k): The passivation 9 is removed at a selected number of positions 10 depending on the mask design to provide accesses to the top electrodes 5.

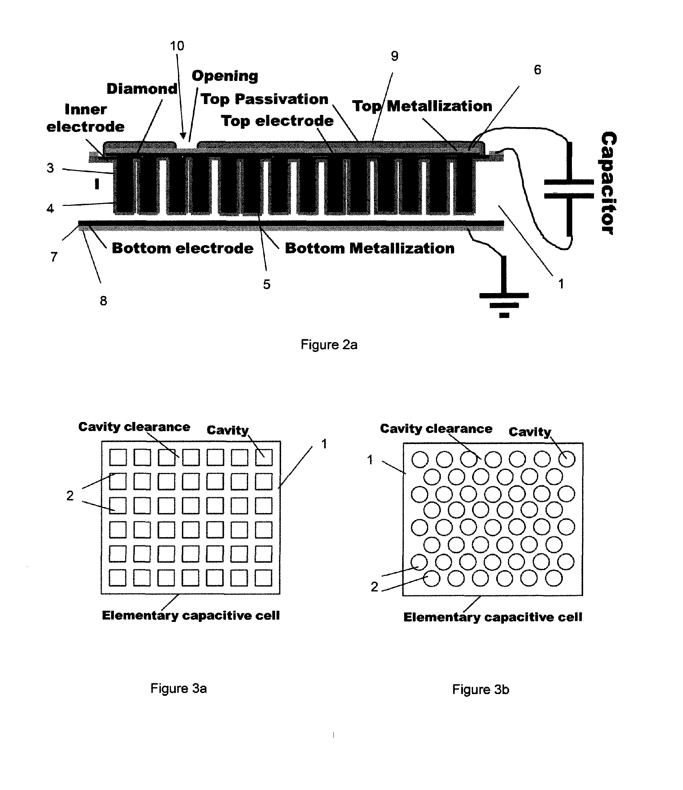

The main process steps have been listed above for the manufacturing of an elementary capacitive cell according to an embodiment of the present invention. The method results in the two final configurations as shown in Figures 2a and 2b. Figure 2a shows the full N++ substrate configuration, Figure 2b shows the intrinsic substrate configuration.

When the substrate 1 is composed of intrinsic silicon, instead of full N++ substrate (highly conductive substrate), the bottom electrode 6 is not an active electrode and must be connected to the lowest potential/net (typically the ground potential). When the substrate 1 is composed of full N++ substrate (highly conductive substrate) instead of intrinsic silicon, the inner electrode is composed of the N++ substrate itself and it is mechanically and electrically connected to the bottom electrode 6.

The elementary capacitive cell stack-up and geometry has been defined above. In some embodiments, dimensions for each cell may be within the ranges set out below:

Wafer diameter: from about 4 to 20 inches

Wafer thickness: from about 200 $\mu$m to 1 mm

Intrinsic doping concentration: about $10^{-9}$ to $10^{-11}$ cm$^{-3}$

N++ doping concentration: about $10^{-13}$ to $10^{-20}$ cm$^{-3}$

Cavity depth: from about 50 $\mu$m to 400 $\mu$m. In some embodiments, the depth may be about 150$\mu$m

Cavity width or diameter: from about 0.5 $\mu$m to 20 $\mu$m. In some embodiments, the width may be about 1$\mu$m

Ratio Cavity depth / Cavity width or diameter: about 10 to 100

Inner electrode thickness: from 10 nm to 100 $\mu$m. In some embodiments, the thickness may be about 200nm to 1 $\mu$m.

Diamond dielectric thickness: from 10 nm to 100 $\mu$m. In some embodiments, the thickness may be about 100nm to 1 $\mu$m

Top electrode thickness: from 10 nm to 100 $\mu$m. In some embodiments, the thickness may be about 200nm to 1 $\mu$m

Top metallization thickness: from 10nm to 100$\mu$m. In some embodiments, the thickness may be about 500nm to 2$\mu$m

Bottom metallization thickness: from 10 nm to 100 $\mu$m. In some embodiments, the thickness may be about 500nm to 2 $\mu$m

Passivation thickness: from 10 nm to 100 $\mu$m. In some embodiments, the thickness may be about 1$\mu$m to 10 $\mu$m

Passivation opening: about 50$\mu$m to 500 $\mu$m length (square or rectangular opening)

Single die size (from wafer cutting): about 0.2 mm to 12 mm length (square or rectangular die shape). In some embodiments, the square or rectangular chip/die may be about $1\times1$ mm$^2$ to $6\times6$mm$^2$

Single die thickness (with or without grinding): from 150 $\mu$m to 400 $\mu$m. In some embodiments, the thickness may be about 400$\mu$m

*Cavity geometries*

Depending on the precise mechanical and electrical optimal design, different cavity geometries may be used in embodiments of the present invention. Figures 3a-3d show the top view geometries (mask design) of four examples of a substrate 1 with a plurality of cavities 2:

Figure 3a shows square cavities (inversed micro-post)

Figure 3b shows circular cavities (inversed micro-fingers)

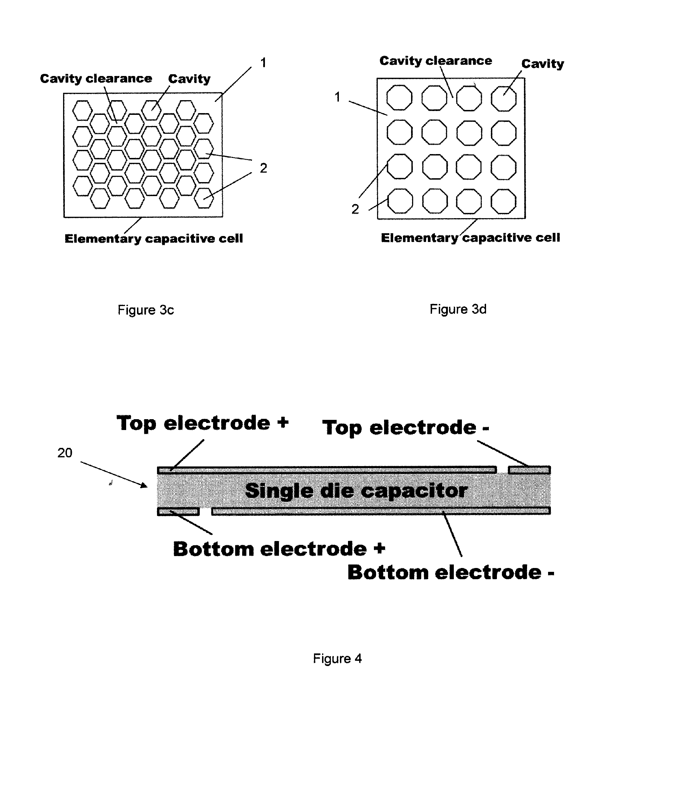

Figure 3c shows hexagonal cavities ("nid d'abeille")

Figure 3d shows octagonal cavities (other polygonal shapes are also possible)

For each of the geometries listed above, a filling factor may be defined as the ratio from the top view between the cavity area and the elementary capacitive cell area. Merely by way of example, the filling factor may in some aspects range from about 0.1 to 0.9.

*Die stacking and microelectronics packaging*

In some embodiments, by adding silicon vias (through hole cavity /metallized via) and special electrode geometries, the initial process described above may be optimized to stack dies of individual capacitor cells. Two examples of stacked die configurations according to embodiments of the present invention will now be described

**Example 1**

In this example, bottom and top electrodes are designed to be placed and metalized on each side of the die (top and bottom side) in order to stack the same die. Merely by way of example, in some aspects, the number of stacked dies within a stack may ranges from 2 to 20.

The geometry and electrode design of a single die 20 is shown in Figure 4. The die has top and bottom positive and negative electrodes as indicated.

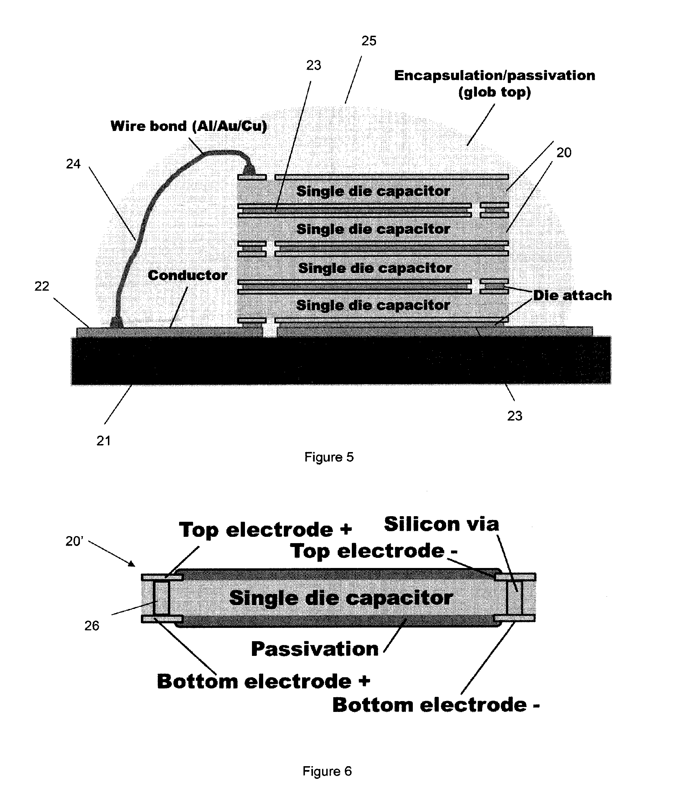

Figure 5 shows a plurality of stacked dies 20 on a metalized substrate 21 which is covered by a conductor 22 which is a conductive material with appropriate plating for metallurgical compatibility with die attaches and/or wire bonding processes.

The metallized substrate is a Printed Circuit Board (PCB) or a metallized ceramic substrate. In some embodiments, the materials are polyimide and FR4 for PCBs, and $Al_2O_3$, AIN or $Si_3N_4$ for metallized ceramic substrates (known as DBC, DBA, AMB or HTCC ceramic substrates).

In some embodiments, the dies 20 are attached to each other and to the conductor 22 by a die attach material 23. which may be a conductive or non-conductive bonding material. In the nonconductive embodiment, the die may not be conductive and stacked dies for some hybrid assembly configurations may be connected by wire bonds (*e.g.* if capacitor die/chip is mounted on another which is larger, or the opposite way around.

A wire bond 24 is provided which is a micro-wire that enables the electrical connection between the top of the stack and the conductor 22. Materials for the wire bond may include Au, AuSi, AuPd, Al, Cu and/or the like.

An outer encapsulation or passivation 25 may surround the stack and may comprise an insulating material to protect the assembly. The encapsulation or passivation 25 may comprise silicones, other polymers and/or epoxies. For some hermetic packaged systems, encapsulation may not be required.

**Example 2**

In this example, the stacked dies are implemented using silicon vias 26 on the edges or extremities of the dies 20' as shown in Figure 6 which shows the geometry and electrode design of a single die 20'.

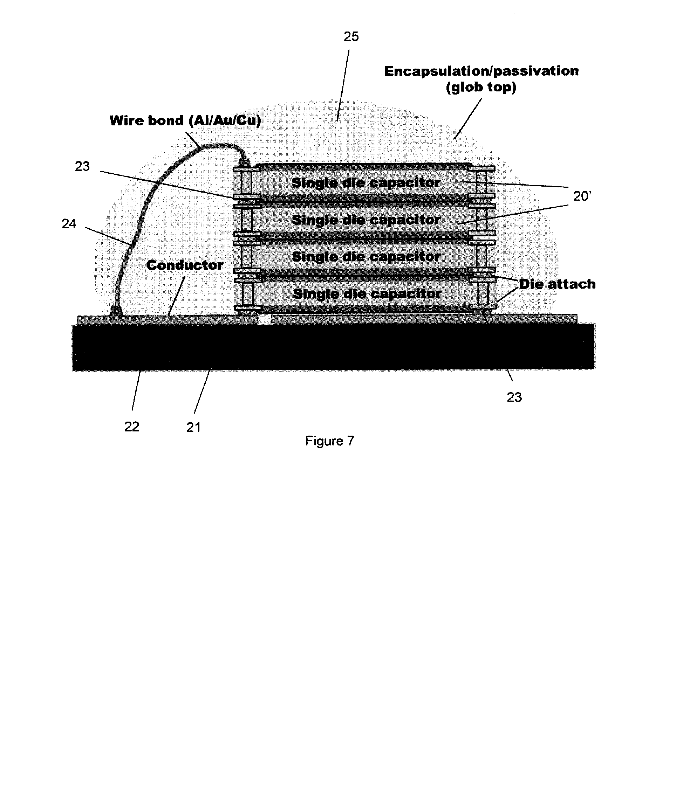

Figure 7 shows a plurality of stacked dies 20' as shown in Figure 5 stacked on a metalized substrate 21. The reference numerals used in these figures correspond to the same features as set out in respect of Example 1 above, and the stacked die shown in Figure 7 will not be described further here.

*Material Properties*

The following material properties are expected from diamond active layers:

| Material | Function | Dielectric constant $\varepsilon_r$ (no unit) | Breakdown electric fields (kV/mm) | Resistivity $\rho$ ($\Omega$.m) | Bandgap energy (eV) | Thermal conductivity (W·m$^{-1}$·K$^{-1}$) |
|---|---|---|---|---|---|---|
| Diamond | Insulator | 5.7-11 | 1000-2000 | $10^{10}$-$10^{12}$ | 5.6 | 2000 |
| Diamond P-doped | Conductor | ? | N/A | ? | N/A | 2000 |

Calculations of the properties of capacitors according to embodiments of the present invention are now set out. These calculations are based on specific capacitor die configurations and are provided by way of example only to demonstrate the potential electrical properties of capacitor cells and capacitors according to embodiments of the invention.

Symbols:

| | |
|---|---|
| Ec_SiO2 | SiO$^2$ Critical electric field (V/m) |
| Ec_cd | Diamond Critical electric field (V/m) |
| $\varepsilon$c_SiO2 | SiO$^2$ relative permittivity |
| $\varepsilon$c_cd | Diamond relative permittivity |
| $\varepsilon$0 | vaccum permittivity |
| r_ext | Cavity width or diameter with dielectric layer(m) |
| r_int | Cavity width or diameter with no dielectric layer (m) |
| L_motif | Clearance between two cavities (m) |
| L_drie | Cavity depth (m) |
| Vbr_sio2 | Voltage breakdown of SiO$^2$ dielectric layer (V) |
| Vbr_cd | Voltage breakdown of diamond dielectric layer (V) |
| W_sio2 | Stored energy per volume unit in SiO$^2$ dielectric layer (J/m$^3$) |
| W_cd | Stored energy per volume unit in diamond dielectric layer (J/m$^3$) |
| C0_sio2 | Capacitance per surface unit (F/mm$^2$) |
| C0_cd | Capacitance per surface unit (F/mm$^2$) |

Technology performance estimates for capacitor cells in accordance with embodiments of the present invention:

Dielectric material properties:

$$Ec\_sio2 := 2.5 \cdot 10^8 \quad \varepsilon r\_sio2 := 4.1 \quad Ec\ SiO^2\ theorical = 6 - 10\ MV/cm$$
$$Ec\_cd := 10 \cdot 10^8 \quad \varepsilon r\_cd = 5.68 \quad Ec\ diamond\ theorical = 10\text{-}20\ MV/cm$$
$$\varepsilon 0 := 8.8542 10^{-12}$$

Geometry:

$$r\_ext := 0.5 \cdot 10^{-6} \qquad L\_motif := 2 \cdot 10^{-6} \qquad N\_motif := \left(\frac{10^{-3}}{L\_motif}\right)^2 = 2.5 \times 10^5$$

$$r\_int := 0.35 \cdot 10^{-6} \qquad L\_drie := 100 \cdot 10^{-6}$$

Electrical parameters:

$$Vbr\_sio2 := Ec\_sio2 \cdot (r\_ext - r\_int) = 37.5$$

$$Vbr\_cd := Ec\_cd \cdot (r\_ext - r\_int) = 150$$

$$W\_sio2 := \frac{1}{2} \cdot \varepsilon0 \cdot \varepsilon r\_sio2 \cdot Ec\_sio2^2 \cdot 10^{-6} = 1.134 \; J/cm3$$

$$W\_cd := \frac{1}{2} \cdot \varepsilon0 \cdot \varepsilon r\_cd \cdot Ec\_cd^2 \cdot 10^{-6} = 25.146 \; J/cm3$$

$$C0\_sio2 := \left[\frac{\varepsilon0 \cdot \varepsilon r\_sio2 \cdot 2 \cdot \pi \cdot L\_drie}{\ln\left(\dfrac{r\_ext}{r\_int}\right)} + \frac{\varepsilon0 \cdot \varepsilon r\_sio2 \cdot \left(L\_motif^2 - \pi \cdot r\_ext^2\right)}{r\_ext - r\_int}\right] \cdot N\_motif$$

$$C0\_sio2 = 1.618 \times 10^{-8}$$

$$C0\_cd := \left[\frac{\varepsilon0 \cdot \varepsilon r\_cd \cdot 2 \cdot \pi \cdot L\_drie}{\ln\left(\dfrac{r\_ext}{r\_int}\right)} + \frac{\varepsilon0 \cdot \varepsilon r\_cd \cdot \left(L\_motif^2 - \pi \cdot r\_ext^2\right)}{r\_ext - r\_int}\right] \cdot N\_motif$$

$$C0\_cd = 2.242 \times 10^{-8}$$

Capacitance (F) and estimated ratings for typical SMC footprints:

|  |  |  | Cap. Ratings: |
|---|---|---|---|
| 0603 capacitor: 1.6x0.8 | C0603_cd := C0_cd·1.6·0.8 = $2.87 \times 10^{-8}$ | 0603-27nF-100V |
| 0805 capacitor: 2.0x1.25 | C0805_cd := C0_cd·2·1.25 = $5.604 \times 10^{-8}$ | 0805-56nF-100V |
| 1210 capacitor: 3.2x2.5 | C1210_cd := C0_cd·3.2·2.5 = $1.793 \times 10^{-7}$ | 1210-180nF-100V |
| 1812 capacitor: 4.5x3.2 | C1812_cd := C0_cd·4.5·3.2 = $3.228 \times 10^{-7}$ | 1812-330nF-100V |

Comparison: SMT Tantalum cap. 1210, rated 50V ranges from 100nF to 1$\mu$F

In some embodiments, the capacitor cell/die may comprise more than one elementary component. In other embodiments, the capacitor cell/die may comprise one or more resistors where doping concentration may be used to change the diamond resistivity or top layer metallization.

Equivalent Electrical Circuit

In some embodiments, a passive network may comprise several independent capacitors and resistors may be integrated on the same die/chip. Passive networks may comprise stacked dies/chips. In some embodiments, resistors may be made from the top electrode metallization mask design.

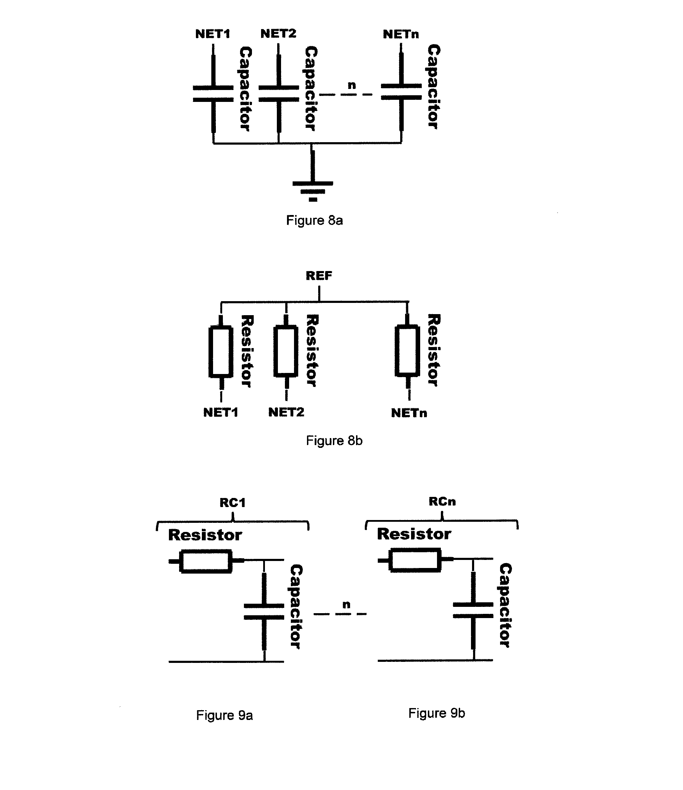

Examples of embodiments of the present invention comprising multiple components are provided in Figs. 8A, 8B. 9A, 9B and 10.

Figs. 8A and 8B illustrate decoupling capacitors, in accordance with embodiments of the present invention, and pull-up/pull-down resistors within the same die/chip.

Figs. 9A and 9B illustrate capacitors, in accordance with embodiments of the present invention, incorporated in resistor-capacitor (RC) filters.

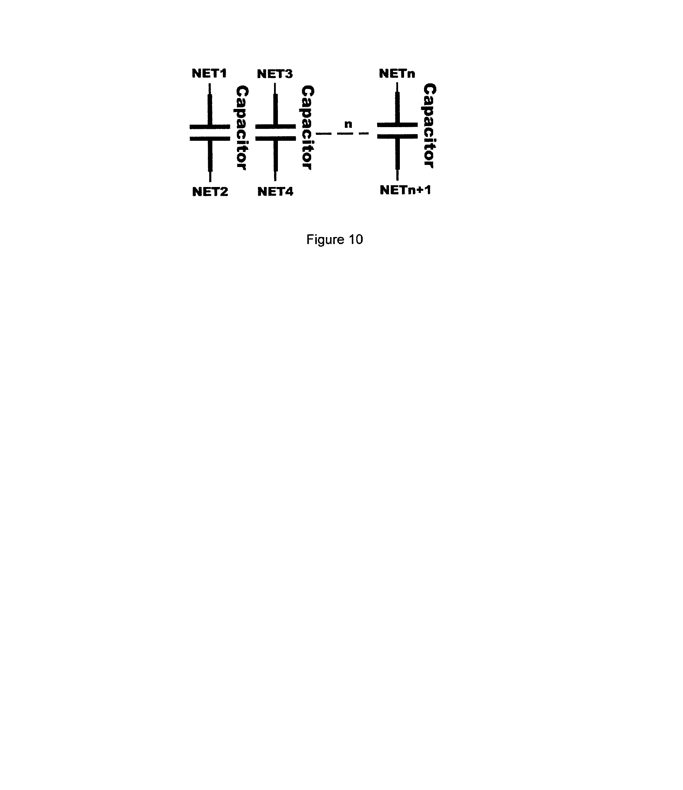

Fig. 10 illustrates capacitors, in accordance with embodiments of the present invention, integrated in a circuit as by-pass capacitors/analog capacitors.

While the invention has been described in conjunction with the exemplary embodiments described above, many equivalent modifications and variations will be apparent to those skilled in the art when given this disclosure. Accordingly, the exemplary embodiments of the invention set forth above are considered to be illustrative and not limiting. Various changes to the described embodiments may be made without departing from the scope of the invention.

**Claims**

1. A capacitor cell comprising:

   a semi-conductor assembly comprising a substrate of semi-conductor material having a plurality of cavities etched into a top surface thereof;
   a dielectric insulator layer of crystalline diamond formed on said semi-conductor assembly;
   a top layer electrode formed on said diamond layer;
   a bottom layer electrode formed on a bottom surface of the substrate of said semi-conductor assembly ; and
   an insulating layer formed on said top electrode layer and having a plurality of openings to provide access to said top electrode layer.

2. A capacitor cell according to claim 1, wherein the substrate is made of intrinsic semi-conductor material and the semi-conductor assembly also comprises an inner electrode formed on top surface of the substrate, the dielectric insulator layer being formed on the inner electrode.

3. A capacitor cell according to claim 2, wherein the inner electrode is a layer of ion.implanted n-type dopant.

4. A capacitor cell according to claim 2 wherein the inner electrode is metal or a multilayer metallization.

5. A capacitor cell according to claim 1, wherein substrate is made of highly doped n-type semi-conductor material, the dielectric insulator layer being formed on the substrate.

6. A capacitor cell according to any one of the preceding claims wherein the top layer electrode is a thin layer of highly doped crystalline diamond.

7. A capacitor cell according to any one of the preceding claims wherein the top layer electrode is metallized.

8. A capacitor cell according to any one of the preceding claims wherein the insulating layer formed on said top electrode layer is a multilayer structure.

9. A capacitor comprising a stack of capacitor cells, each cell being an identical capacitor cell according to any one of the preceding claims, and wherein the cells are connected by bonding the top and bottom layer electrodes of neighbouring cells in the stack to each other.

10. A method of manufacturing a capacitor cell, the method including the steps of:

   etching a plurality of cavities into a top surface of a substrate of semi-conductor material of a semi-conductor assembly;
   depositing a thin layer of crystalline diamond on said semi-conductor assembly as a dielectric insulator layer;
   creating an electrically conductive top layer electrode on said diamond layer;
   finishing said top electrode layer by thin film metallization;
   creating an electrically conductive bottom electrode layer on a bottom surface of said substrate;
   finishing said bottom electrode layer by thin film metallization;
   forming an insulating layer on said top electrode layer; and
   forming openings in said insulating layer to provide access to said top electrode layer.

11. The method of claim 10, wherein the substrate is made of highly doped n-type semi-conductor material, the depositing of the thin layer being on said substrate.

12. The method of claim 10, wherein the substrate is made of intrinsic semi-conductor material, the method comprising a step of forming an inner electrode on top surface of the substrate, the depositing of the thin layer being on said inner electrode.

13. A method according to claim 12, wherein the inner electrode is created by doping with an n-type dopant.

14. A method according claim 12 wherein the inner electrode is formed from metal or a multilayer metallization.

15. A method according to claim 14 wherein the inner electrode is formed by sputtering.

1

Figure 1a

1

2

Figure 1b

N++

3

1

2

Figure 1c

Figure 1d

Figure 1e

Figure 1f

Figure 1g

Figure 1h

Figure 1i

Figure 1j

Figure 1k

Figure 2b

EP 2 999 002 A1

Figure 2a

Figure 3a

Figure 3b

Cavity clearance    Cavity

1

2

Elementary capacitive cell

Cavity clearance    Cavity

1

2

Elementary capacitive cell

Figure 3c

Figure 3d

Top electrode +    Top electrode -

20

Single die capacitor

Bottom electrode +

Bottom electrode -

Figure 4

25

23

**Encapsulation/passivation (glob top)**

**Wire bond (Al/Au/Cu)**

24

20

Single die capacitor

Single die capacitor

22

**Conductor**

Single die capacitor

Single die capacitor

**Die attach**

21

23

Figure 5

20'

**Top electrode +**   **Silicon via**

**Top electrode -**

26

Single die capacitor

**Passivation**

**Bottom electrode +**

**Bottom electrode -**

Figure 6

25

Encapsulation/passivation
(glob top)

Wire bond (Al/Au/Cu)

23

24

Conductor

Single die capacitor

Single die capacitor

Single die capacitor

Single die capacitor

20'

Die attach

23

22          21

Figure 7

Figure 8a

Figure 8b

Figure 9a                    Figure 9b

Figure 10

Europäisches
Patentamt

European
Patent Office

Office européen
des brevets

# EUROPEAN SEARCH REPORT

Application Number

EP 14 29 0286

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 5 759 903 A (LEHMANN VOLKER [DE] ET AL) 2 June 1998 (1998-06-02) <br> * abstract; figure 1 * <br> * column 3, line 26 - line 50 * <br> * column 5, line 16 - line 43 * <br> ----- | 1-15 | INV. <br> H01L29/94 <br> H01L23/64 <br> H01L29/66 <br> H01G4/08 <br> H01L21/314 |
| Y | HEIDGER S ET AL: "Dielectric characterization of microwave assisted chemically vapor deposited diamond", AEROSPACE AND ELECTRONICS CONFERENCE, 1998. NAECON 1998. PROCEEDINGS O F THE IEEE 1998 NATIONAL DAYTON, OH, USA 13-17 JULY 1998, NEW YORK, NY, USA,IEEE, US, 13 July 1998 (1998-07-13), pages 247-254, XP010298875, DOI: 10.1109/NAECON.1998.710124 ISBN: 978-0-7803-4449-5 <br> * Chapter "Introduction"; page 247, right-hand column * <br> * References; page 254 * <br> ----- | 1-15 | |
| Y | US 2012/012982 A1 (KOREC JACEK [US] ET AL) 19 January 2012 (2012-01-19) <br> * paragraphs [0024] - [0031]; figures 1-6 * <br> ----- | 1-15 | TECHNICAL FIELDS SEARCHED (IPC) <br><br> H01L <br> H01G |
| Y | US 2010/330766 A1 (BERBERICH SVEN [DE]) 30 December 2010 (2010-12-30) <br> * paragraphs [0036] - [0038]; figures 2,3 * <br> ----- <br> -/-- | 1-15 | |

The present search report has been drawn up for all claims

| Place of search | Date of completion of the search | Examiner |
|---|---|---|
| Munich | 6 March 2015 | Mosig, Karsten |

EPO FORM 1503 03.82 (P04C01)

Europäisches
Patentamt

European
Patent Office

Office européen
des brevets

# EUROPEAN SEARCH REPORT

Application Number

EP 14 29 0286

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | ROOZEBOOM ET AL: "High-value MOS capacitor arrays in ultradeep trenches in silicon", MICROELECTRONIC ENGINEERING, ELSEVIER PUBLISHERS BV., AMSTERDAM, NL, vol. 53, no. 1-4, 1 June 2000 (2000-06-01) , pages 581-584, XP022553250, ISSN: 0167-9317 * page 581; figure 1 * | 2-4, 12-14 | |
| Y | US 2010/264426 A1 (BLAIR CHRISTOPHER [US]) 21 October 2010 (2010-10-21) * paragraphs [0028], [0032]; figures 1a, 1b, 2 * | 6 | |
| A | US 2003/183866 A1 (SANCHEZ JEAN-LOUIS [FR] ET AL) 2 October 2003 (2003-10-02) * the whole document * | 1-15 | |

TECHNICAL FIELDS
SEARCHED (IPC)

The present search report has been drawn up for all claims

| Place of search | Date of completion of the search | Examiner |
|---|---|---|
| Munich | 6 March 2015 | Mosig, Karsten |

EPO FORM 1503 03.82 (P04C01)

## ANNEX TO THE EUROPEAN SEARCH REPORT
## ON EUROPEAN PATENT APPLICATION NO.

EP 14 29 0286

This annex lists the patent family members relating to the patent documents cited in the above-mentioned European search report.
The members are as contained in the European Patent Office EDP file on
The European Patent Office is in no way liable for these particulars which are merely given for the purpose of information.

06-03-2015

| Patent document cited in search report | | Publication date | Patent family member(s) | Publication date |
|---|---|---|---|---|
| US 5759903 | A | 02-06-1998 | BR 9203128 A<br>EP 0528281 A2<br>FI 923629 A<br>JP 3310344 B2<br>JP H05198741 A<br>RU 2082258 C1<br>US 5759903 A | 30-03-1993<br>24-02-1993<br>15-02-1993<br>05-08-2002<br>06-08-1993<br>20-06-1997<br>02-06-1998 |
| US 2012012982 | A1 | 19-01-2012 | NONE | |
| US 2010330766 | A1 | 30-12-2010 | BR PI1000868 A2<br>CN 101847600 A<br>DE 102009001919 A1<br>EP 2234146 A2<br>JP 2010232655 A<br>KR 20100108256 A<br>US 2010330766 A1 | 22-03-2011<br>29-09-2010<br>30-09-2010<br>29-09-2010<br>14-10-2010<br>06-10-2010<br>30-12-2010 |
| US 2010264426 | A1 | 21-10-2010 | NONE | |
| US 2003183866 | A1 | 02-10-2003 | AT 322084 T<br>AU 5852001 A<br>CA 2409683 A1<br>DE 60118358 T2<br>EP 1287564 A1<br>FR 2808924 A1<br>JP 4868683 B2<br>JP 2003535461 A<br>US 2003183866 A1<br>WO 0186729 A1 | 15-04-2006<br>20-11-2001<br>15-11-2001<br>14-12-2006<br>05-03-2003<br>16-11-2001<br>01-02-2012<br>25-11-2003<br>02-10-2003<br>15-11-2001 |

EPO FORM P0459

For more details about this annex : see Official Journal of the European Patent Office, No. 12/82